(19) Europäisches Patentamt
European Patent Office
Office européen des brevets

(11) EP 3 893 272 A1

(12) EUROPEAN PATENT APPLICATION
published in accordance with Art. 153(4) EPC

(43) Date of publication:
**13.10.2021 Bulletin 2021/41**

(21) Application number: **19893905.0**

(22) Date of filing: **28.11.2019**

(51) Int Cl.:
***H01L 23/12*** (2006.01) ***H01L 23/14*** (2006.01)
***H01L 23/36*** (2006.01) ***H05K 1/02*** (2006.01)
***H05K 1/03*** (2006.01) ***H05K 3/46*** (2006.01)

(86) International application number:
**PCT/JP2019/046537**

(87) International publication number:
**WO 2020/116306 (11.06.2020 Gazette 2020/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.12.2018 JP 2018227171**

(71) Applicant: **Kuraray Co., Ltd.**
**Kurashiki-shi, Okayama 710-0801 (JP)**

(72) Inventors:
- **SUNAMOTO, Tatsuya**
**Tokyo 100-8115 (JP)**
- **ONODERA, Minoru**
**Kurashiki-shi, Okayama 710-0801 (JP)**

(74) Representative: **Vossius & Partner**
**Patentanwälte Rechtsanwälte mbB**
**Siebertstraße 3**
**81675 München (DE)**

# (54) HIGH VOLTAGE CIRCUIT BOARD AND HIGH VOLTAGE DEVICE USING SAME

(57) Provided are a circuit board including an insulating layer including a thermoplastic liquid crystal polymer and having excellent insulation reliability under a high voltage; and a high voltage device using the same. The circuit board (30) is a high voltage circuit board including an insulating layer (31) and a high voltage circuit layer (34), wherein the insulating layer includes a thermoplastic liquid crystal polymer. It is preferable that the circuit board includes a heat dissipation part (39) for dissipating heat from the insulating layer (31).

Fig. 3

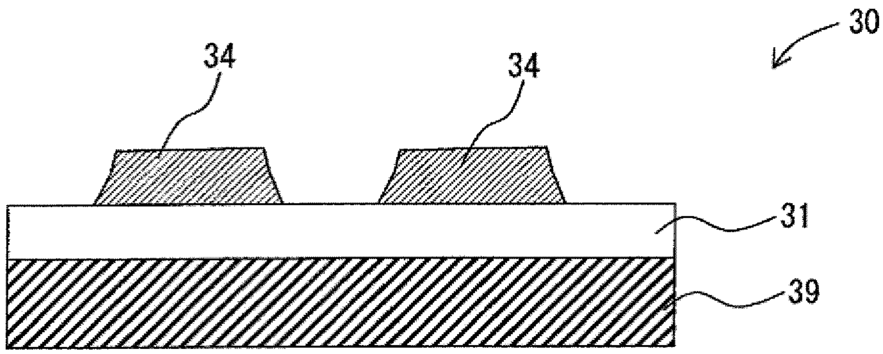


EP 3 893 272 A1

## Description

CROSS REFERENCE TO THE RELATED APPLICATION

This application claims priority to Japanese patent application No. 2018-227171, filed December 4, 2018 in Japan, the entire disclosure of which is incorporated by reference into this application.

FIELD OF THE INVENTION

The present invention relates to a circuit board comprising an insulating layer formed of a thermoplastic liquid crystal polymer being capable of forming an optically anisotropic molten phase, and having excellent insulation reliability under high voltage.

BACKGROUND OF THE INVENTION

As a power control device, there have been known a variety of devices in which various electronic elements are mounted on circuit boards, for example, inverter devices, power semiconductor devices, etc. The number of these power control devices to be used has been increasing year by year. In particular, densified devices with small size while exhibiting high voltage have been required in order to realize large capacity, high efficiency, and small space to be occupied.

However, making circuit boards to be densified and have high voltage and small size may cause migration that is occurred by movement of metal used as wiring or electrodes on insulating substance, and as a result, insulation failure may occur in the circuit boards. Occurrence of migration may eventually cause a short circuit in a circuit board in a system so as to accompany destruction of the system. The occurrence of migration depends on electric field strength, distance between electrodes, and pulse frequency applied to the electrodes, and in particular, is greatly affected by a temperature of the circuit board as well as moisture adsorption of the circuit board. In general, migration is likely to occur on a circuit board having a large hygroscopic nature.

For example, in order to prevent migration deterioration, Patent Document 1 (JP Laid-open Patent Publication No. 2010-186789) describes the insulating layer in an insulating circuit board wherein a conductor circuit is formed on a metal base substrate via an insulating layer; the insulating layer is a multilayered laminate comprising at least a composite insulating layer and a polymeric insulating layer free from inorganic fillers; and the composite insulating layer contains inorganic fillers dispersed in an insulating resin.

CONVENTIONAL ART DOCUMENT

PATENT DOCUMENT

[Patent Document 1] JP Laid-open Patent Publication No. 2010-186789

SUMMARY OF THE INVENTION

PROBLEMS TO BE SOLVED BY THE INVENTION

However, in the insulating circuit board used in Patent Document 1, it is too complicated to produce such an insulating circuit board because of the necessity of laminating the composite insulating layer and the polymeric insulating layer. Further, since the inorganic fillers contain a large amount of impurity ions such as chlorine ions, use of a composite insulating layer containing inorganic fillers dispersed in the insulating resin still fails to suppress migration occurrence caused by the compounding of the inorganic filler and the insulating resin.

An object of the present invention is to provide a circuit board which comprises an insulating layer formed of a thermoplastic liquid crystal polymer and has excellent insulation reliability under a high voltage.

Another object of the present invention is to provide a circuit board capable of exhibiting insulation reliability even running at a high voltage and a short pulse.

Still another object of the present invention is to provide a circuit board having excellent insulation reliability at high temperatures.

MEANS FOR SOLVING THE PROBLEMS

As a result of intensive studies to achieve the above objects, the inventors of the present invention firstly have

found that, although it has been conventionally recognized that the insulation reliability of the thermoplastic liquid crystal polymer is comparable to that of other materials under a low voltage, surprisingly, under high voltage, the insulation reliability of the thermoplastic liquid crystal polymer is extremely good as compared with other materials. In the light of the above findings, the inventors achieved the present invention.

Accordingly, the present invention may include the following aspects.

Aspect 1 A high voltage circuit board at least including: an insulating layer including a thermoplastic liquid crystal polymer, and a high voltage circuit layer.
Aspect 2 The high voltage circuit board according to the aspect 1, wherein the insulating layer has a relative permittivity of 3.5 or less (for example about from 1.8 to 3.5, more preferably about from 2.5 to 3.4) at 1 GHz.
Aspect 3 The high voltage circuit board according to the aspect 1 or 2, further including a heat dissipation part for dissipating heat from the insulating layer.
Aspect 4 The high voltage circuit board according to any one of the aspects 1 to 3, wherein the insulating layer is an inorganic-filler free polymeric insulating layer.
Aspect 5 The high voltage circuit board according to any one of the aspects 1 to 4, wherein the insulating layer has a thickness of from 25 to 1000 $\mu$m (preferably about from 25 to 800 $\mu$m, more preferably about from 50 to 700 $\mu$m, still preferably about from 100 to 500 $\mu$m).
Aspect 6 The high voltage circuit board according to any one of the aspects 1 to 5, wherein the insulating layer has a segment orientation ratio SOR of from 0.8 to 1.4 (preferably from 0.9 to 1.3, more preferably from 1.0 to 1.2, still more preferably from 1.0 to 1.1).
Aspect 7 The high voltage circuit board according to any one of the aspects 1 to 6, which is used as a pulse control board.
Aspect 8 The high voltage circuit board according to any one of the aspects 1 to 7, which is used as a power semiconductor device.
Aspect 9 A high voltage device including: the high voltage circuit board according to any one of the aspects 1 to 8, and an electronic element.
Aspect 10 A power semiconductor device including: the high voltage circuit board according to any one of the aspects 1 to 8, and a power semiconductor element.

It should be noted that any combination of claims and/or at least two components disclosed in the specification and/or drawings is included in the present invention. In particular, any combination of two or more of the claims described in the claims is included in the present invention.

## EFFECT OF THE INVENTION

Since the high voltage circuit board according to the invention comprises an insulating layer of a thermoplastic liquid crystal polymer, the circuit board is excellent in insulation reliability under high voltage. Further, the high voltage circuit board according to the present invention can exhibit good insulation reliability even when running at a high voltage and a short pulse.

The high voltage circuit board according to the present invention can suppress the occurrence of migration even under high humidity conditions. Further, it is possible to suppress the occurrence of dielectric breakdown of the high voltage circuit board even under high temperature conditions so that high voltage circuit board can achieve good insulation reliability even when running at a high voltage under high temperatures.

## BRIEF DESCRIPTION OF THE DRAWINGS

In any event, the present invention will be more clearly understood from the following description of preferred embodiments thereof, when taken in conjunction with the accompanying drawings. However, the embodiments and the drawings are given only for the purpose of illustration and explanation, and are not to be taken as limiting the scope according to the present invention in any way whatsoever, which scope is to be determined by the appended claims. In the accompanying drawings, like reference numerals are used to denote like parts throughout the several views. In the figures,

Fig. 1 is a schematic cross-section view illustrating a high voltage circuit board according to one embodiment of the present invention;
Fig. 2 is a schematic cross-section view illustrating a high voltage circuit board according to one embodiment of the present invention;
Fig. 3 is a schematic cross-section view illustrating a high voltage circuit board according to one embodiment of the

present invention; and

Fig. 4 is a schematic cross-section view illustrating a high voltage device according to one embodiment of the present invention.

DESCRIPTION OF THE EMBODIMENTS

The high voltage circuit board according to the present invention is a circuit board including an insulating layer and a high voltage circuit layer, and the insulating layer comprises a thermoplastic liquid polymer. The insulating layer comprising a thermoplastic liquid crystal polymer enables to suppress occurrence of dielectric breakdown because such an insulating layer hardly causes migration at high voltage (particularly at high voltage and short pulse) probably due to prevention of polarization and orientation of the thermoplastic liquid crystal polymer caused by external electric field. Here, the term high voltage means a voltage of 500 V or higher, and the term short pulse means a pulse of 1 millisecond pulse to 1 microsecond pulse having a pulse width of 1 kHz to 1 MHz.

Further, since the thermoplastic liquid crystal polymer is less hygroscopic, it is possible to suppress the occurrence of migration at a high humidity condition (for example, 70% RH or more, preferably 80% RH or more, more preferably 90% RH or more), particularly at the high humidity condition described above and a high temperature condition (for example, 70°C or higher, preferably 75°C or higher, more preferably from 80 to 150°C). Accordingly, the high voltage circuit board can suppress dielectric breakdown due to high voltage and short pulse even under high humidity condition (particularly high temperature and high humidity condition).

Thermoplastic Liquid Crystal Polymer

The Thermoplastic Liquid Crystal Polymer is not particularly limited to a specific one regarding chemical structures as long as it is a melt-moldable liquid crystal polymer (a polymer capable of forming an optically anisotropic melt phase). Examples of the thermoplastic liquid crystal polymer may include a thermoplastic liquid crystal polyester and a thermoplastic liquid crystal polyester amide in which an amide bond is introduced therein.

The thermoplastic liquid crystal polymer may also be a polymer in which, for example, an imide bond, a carbonate bond, a carbodiimide bond and/or a bond derived from an isocyanate, e.g., an isocyanurate bond are/is further introduced to an aromatic polyester or an aromatic polyester amide.

Specific examples of the thermoplastic liquid crystal polymer used in the present invention may include known thermoplastic liquid crystal polyesters and thermoplastic liquid crystal polyester amides obtained from compounds classified as (1) to (4) as exemplified in the following, and derivatives thereof. However, it is needless to say that, in order to form a polymer crystal, there is a suitable range regarding the combination of various raw-material compounds.

(1) Aromatic or aliphatic dihydroxyl compounds (see Table 1 for representative examples)

[Table 1]

| Chemical structural formulae of representative examples of aromatic or aliphatic dihydroxyl compounds | |
|---|---|
| 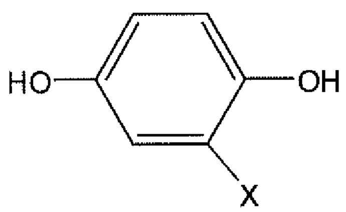 | X represents a hydrogen atom or a halogen atom, or a group such as a lower alkyl (e.g., $C_{1-3}$ alkyl) or a phenyl |
| 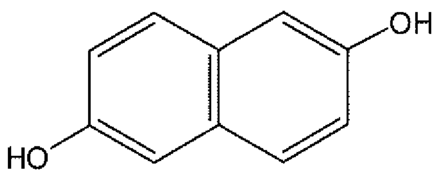 | 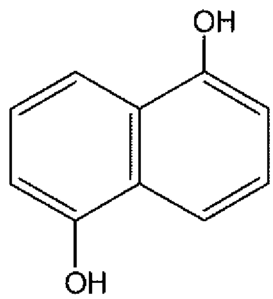 |

(continued)

| Chemical structural formulae of representative examples of aromatic or aliphatic dihydroxyl compounds | |
|---|---|
| 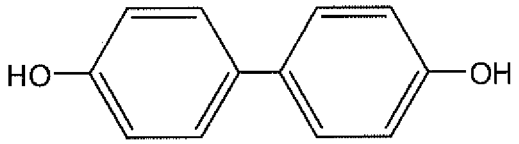 | |
| 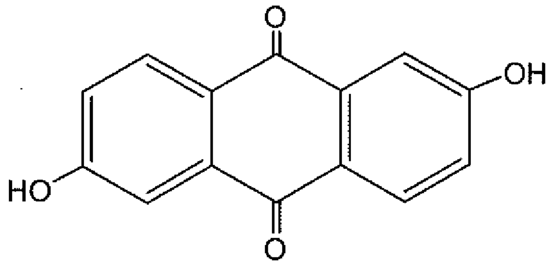 | 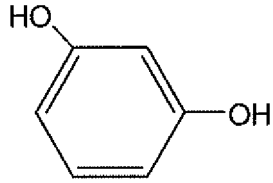 |
| 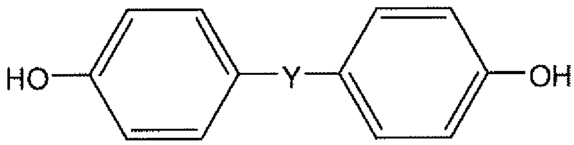 | Y represents a group such as -O-, $-CH_2-$, -S-, -CO-, $-C(CH_3)_2-$, or $-SO_2-$ |
| $HO(CH_2)_nOH$ | n is an integer of 2 to 12 |

(2) Aromatic or aliphatic dicarboxylic acids (see Table 2 for representative examples)

[Table 2]

| Chemical structural formulae of representative examples of aromatic or aliphatic dicarboxylic acids | |
|---|---|
| 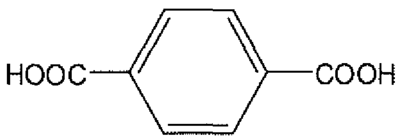 | 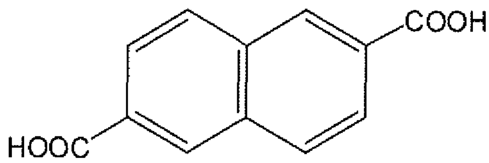 |
| 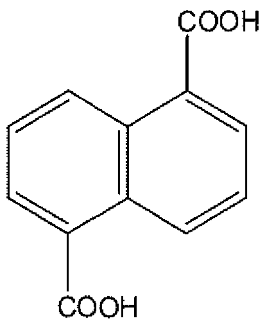 | 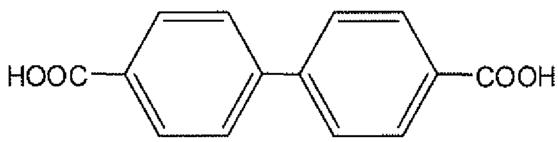 |
| 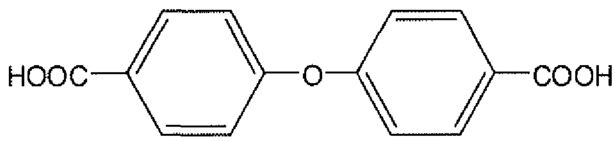 | |
| 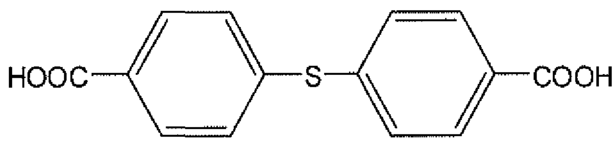 | |

(continued)

| Chemical structural formulae of representative examples of aromatic or aliphatic dicarboxylic acids | |
|---|---|
| 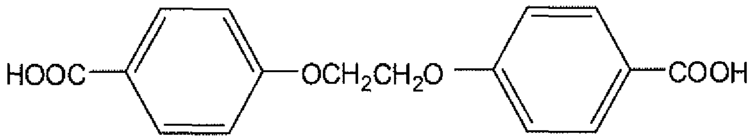 | |
| 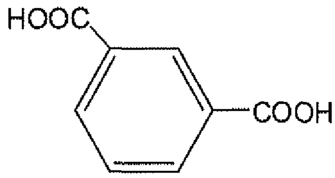 | |
| $HOOC(CH_2)_nCOOH$ | n is an integer of 2 to 12 |

(3) Aromatic hydroxycarboxylic acids (see Table 3 for representative examples)

[Table 3]

| Chemical structural formulae of representative examples of aromatic hydroxycarboxylic acids | |
|---|---|
| 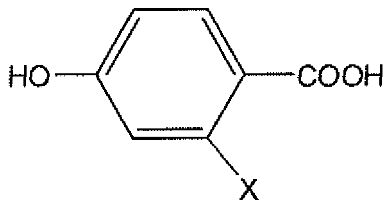 | X represents a hydrogen atom or a halogen atom, or a group such as a lower alkyl (e.g., $C_{1-3}$ alkyl) or a phenyl |
| 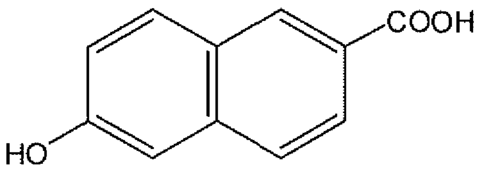 | 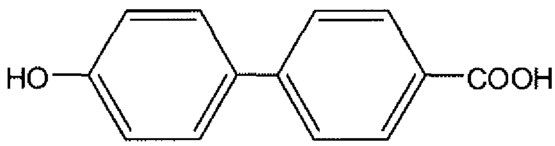 |
| 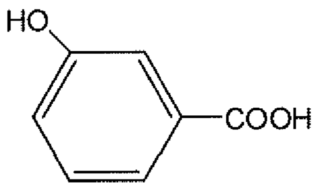 | |

(4) Aromatic diamines, aromatic hydroxy amines, or aromatic aminocarboxylic acids (see Table 4 for representative examples)

[Table 4]

| Chemical structural formulae of representative examples of aromatic diamines, aromatic hydroxy amines, or aromatic aminocarboxylic acids |
|---|
| 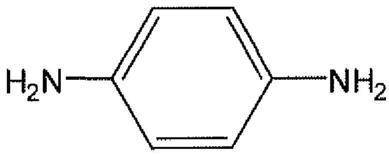 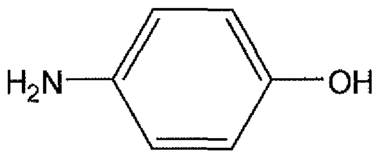 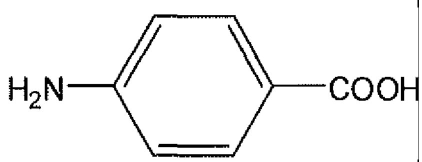 |

Representative examples of thermoplastic liquid crystal polymers obtained from these raw-material compounds may include copolymers having structural units shown in Tables 5 and 6.

[Table 5]

| Representative examples (1) of thermoplastic liquid crystal polymer |
|---|
| (A) 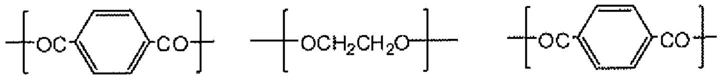 |
| (B) 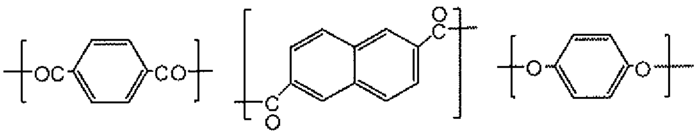 |
| (C) 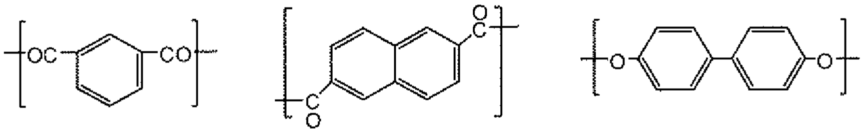 |
| (D) 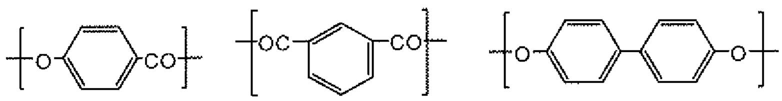 |
| (E) 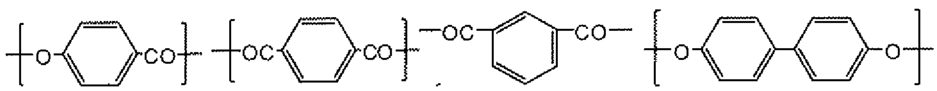 |
| (F) 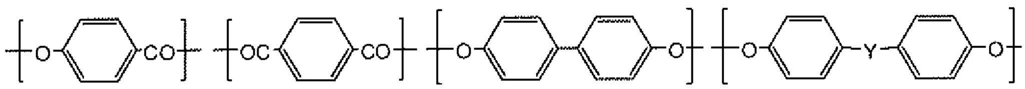 Y is a group such as -O-, -S-, or $-CH_2-$ |
| (G) 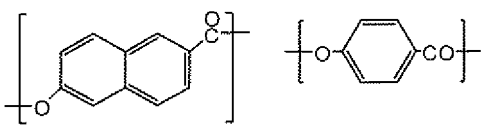 |
| (H) 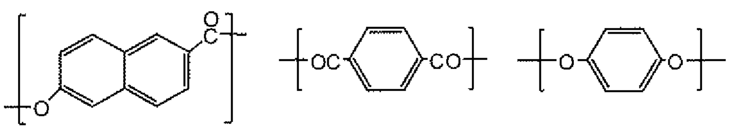 |
| (I) 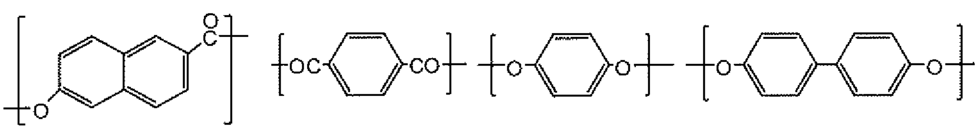 |

(continued)

| Representative examples (1) of thermoplastic liquid crystal polymer |
|---|
| (J) 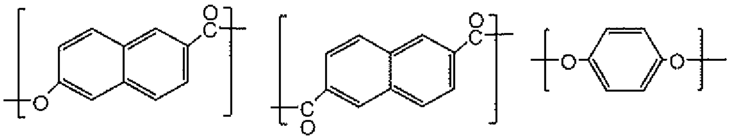 |

[Table 6]

| Representative examples (2) of thermoplastic liquid crystal polymer |
|---|
| (K) 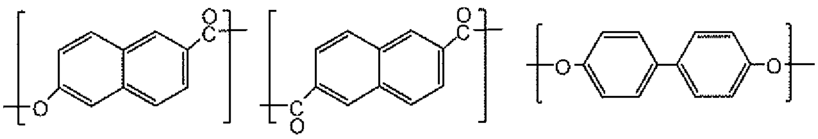 |
| (L) 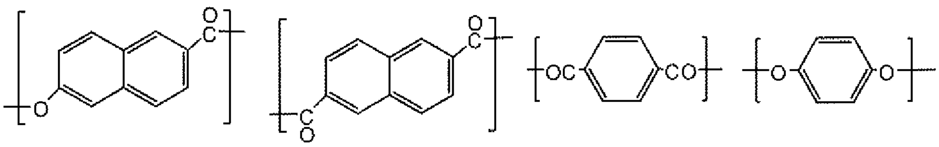 |
| (M) 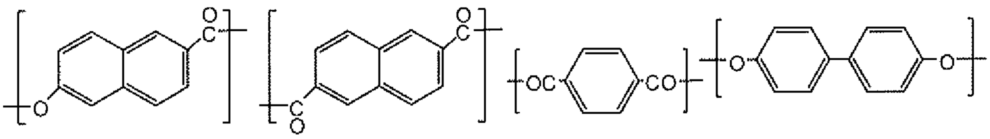 |
| (N) 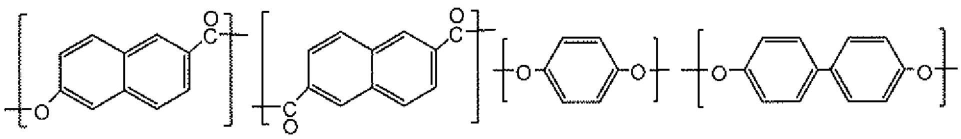 |
| (O) 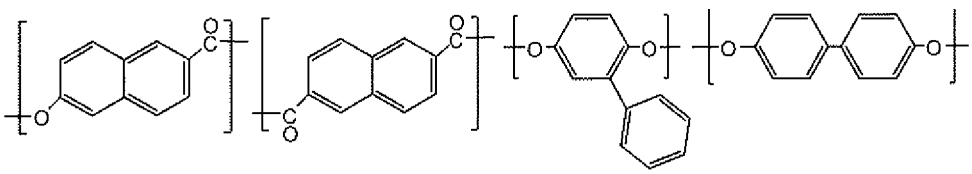 |
| (P) 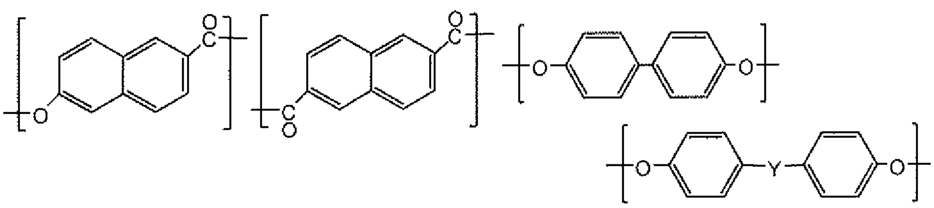 Y is a group such as -O-, -S-, or $-CH_2-$ |
| (Q) 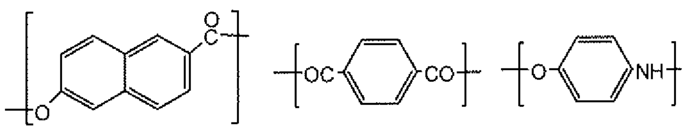 |

Of these copolymers, copolymers including at least p-hydroxybenzoic acid and/or 6-hydroxy-2-naphthoic acid as repeating structural units are preferable; and particularly preferred copolymers include:

a copolymer (i) having repeating structural units of p-hydroxybenzoic acid and 6-hydroxy-2-naphthoic acid, and
a copolymer (ii) having repeating structural units of

at least one aromatic hydroxycarboxylic acid selected from a group consisting of p-hydroxybenzoic acid and 6-hydroxy-2-naphthoic acid,
at least one aromatic diol, and
at least one aromatic dicarboxylic acid.

For example, in the case where the copolymer (i) comprises a thermoplastic liquid crystal polymer having repeating structural units of at least p-hydroxybenzoic acid (A) and 6-hydroxy-2-naphthoic acid (B), the liquid crystal polymer may have a mole ratio (A)/(B) of preferably about (A)/(B) = 10/90 to 90/10, more preferably about (A)/(B) = 15/85 to 85/15, further preferably about (A)/(B) = 20/80 to 80/20 in the thermoplastic liquid crystal polymer.

Furthermore, in the case where the polymer (ii) comprises a liquid crystal polymer having repeating structural units of at least one aromatic hydroxycarboxylic acid (C) selected from a group consisting of p-hydroxybenzoic acid and 6-hydroxy-2-naphthoic acid, at least one aromatic diol (D) selected from a group consisting of 4,4'-dihydroxybiphenyl, hydroquinone, phenylhydroquinone, and 4,4'-dihydroxydiphenylether, and at least one aromatic dicarboxylic acid (E) selected from a group consisting of terephthalic acid, isophthalic acid, and 2,6-naphthalene dicarboxylic acid, the liquid crystal polymer may have a mole ratio of aromatic hydroxycarboxylic acid (C) : aromatic diol (D) : aromatic dicarboxylic acid (E) = 30 to 80 : 35 to 10 : 35 to 10, more preferably about (C):(D):(E) = 35 to 75 : 32.5 to 12.5 : 32.5 to 12.5, and further preferably about (C):(D):(E) = 40 to 70 : 30 to 15 : 30 to 15.

Furthermore, the molar ratio of the repeating structural unit derived from 6-hydroxy-2-naphthoic acid in the aromatic hydroxycarboxylic acid (C) may be, for example, 85 mol% or more, preferably 90 mol% or more, and yet more preferably 95 mol% or more. The molar ratio of the repeating structural unit derived from 2,6-naphthalenedicarboxylic acid in the aromatic dicarboxylic acid (E) may be, for example, 85 mol% or more, preferably 90 mol% or more, yet more preferably 95 mol% or more.

The aromatic diol (D) may include repeating structural units (D1) and (D2) derived from two different aromatic diols each selected from a group consisting of hydroquinone, 4,4'-dihydroxybiphenyl, phenylhydroquinone, and 4,4'-dihydroxydiphenyl ether. In such a case, the two aromatic diols may have a mole ratio (D1)/(D2) = 23/77 to 77/23, more preferably 25/75 to 75/25, and further preferably 30/70 to 70/30.

Furthermore, the liquid crystal polymer may have a mole ratio of a repeating structural unit derived from an aromatic diol relative to a repeating structural unit derived from an aromatic dicarboxylic acid of preferably (D)/(E) = 95/100 to 100/95. Deviation from this range may tend to result in a low degree of polymerization and deterioration in mechanical strength.

It should be noted that, in the present invention, optical anisotropy in a molten state can be determined by, for example, placing a sample on a hot stage, heating the sample at an elevating temperature under nitrogen atmosphere, and observing light transmitted through the sample.

A referred thermoplastic liquid crystal polymer has a melting point in a range from 260°C to 360°C, and more preferably from 270°C to 350°C. The melting point may be determined by observing thermal behavior of a thermoplastic liquid crystal polymer sample using a differential scanning calorimeter. That is, a melting point of a thermoplastic liquid crystal polymer sample may be determined by subjecting the sample to temperature elevation at a rate of 20°C/min to completely melt the sample, then to rapid cooling the molten polymer at a rate of 50°C/min to 50°C, and again to temperature elevation at a rate of 20°C/min to determine the position of an endothermic peak that occurs during the second temperature increase as the melting point of the polymer sample.

As long as the effect of the present invention is not deteriorated, to the thermoplastic liquid crystal polymer, may be added any thermoplastic polymer such as a polyethylene terephthalate, a modified polyethylene terephthalate, a polyolefin, a polycarbonate, a polyarylate, a polyamide, a polyphenylene sulfide, a polyether ether ketone, and a fluorine resin; and/or various additives, and/or fillers etc.

Metal fillers such as $Al_2O_3$ (alumina), AlN (aluminum nitride), ZnO (zinc oxide); and semimetal (metalloid) fillers such as BN (boron nitride), $SiO_2$ (silica), SiC (silicon dioxide), and $Si_3N_4$ (silicon nitride) can be exemplified as a filler. However, since the thermoplastic liquid crystal polymer not only has excellent heat dissipation but also has a permittivity in a suitable range required for circuit boards, the insulating layer may be an inorganic-filler free polymeric insulating layer.

In the insulating layer used in the present invention, from a viewpoint of suppressing the occurrence of migration, the content of the fillers (for example, metal fillers, particularly alumina) in the insulating layer may be, for example, 5% or less, preferably 3% or less, more preferably 1% or less, and particularly preferably 0%. Where metal fillers, such as alumina, are included as a filler, electric charges may be easily accumulated in the interface between the polymer and each of the metal fillers due to difference in permittivity between the metal fillers and the polymer. As a result, the accumulated charges are likely to cause insulating breakdown. In particular, the permittivity of alumina generally used for heat dissipation is about 9, meaning that permittivity difference from the resin is large. Therefore, there may be some cases that a filler is not included in the insulating layer in a preferred manner.

It is preferred that the insulating layer used in the present invention consists essentially of a thermoplastic liquid crystal polymer. The portion of the thermoplastic liquid crystal polymer in the insulating layer may be, for example, 95%

or more, preferably 97% or more, yet more preferably 99% or more, and particularly preferably 100%. Since the thermoplastic liquid crystal polymer not only has excellent heat dissipation but also has a permittivity in a suitable range required for circuit boards, the thermoplastic liquid crystal polymer excels in insulating reliability even if it is used as a filler-free insulating layer. Moreover, if the thermoplastic liquid crystal polymer is used as a filler-free insulating layer, there is no likelihood that electric charges are accumulated in the interface. Furthermore, the thermoplastic liquid crystal polymer prevents not only moisture absorption, but also interface peeling between fillers and the polymer caused by difference in thermal expansion coefficient between them.

The insulating layer used in the present invention is not particularly limited to a specific one as long as it comprises a thermoplastic liquid crystal polymer. The insulating layer is preferably formed from a thermoplastic liquid crystal polymer film in view of achievement in thinning of the insulating layer. The thermoplastic liquid crystal polymer film is obtained, for example, by extrusion molding of the melt-kneaded thermoplastic liquid crystal polymer.

It is preferable that a stretching treatment is followed by the extrusion molding in order to control the orientation. For example, in the extrusion molding using a T-die method, a molten polymer sheet extruded from a T-die may be stretched in the MD (Machine Direction) and TD (Transverse Direction) at the same time, alternatively a molten polymer sheet extruded from a T-die may be stretched in sequence, first in the MD and then in the TD.

Also, in the extrusion molding using an inflation method, a tubular sheet being melt-extruded from an annular die may be drawn with a predetermined draw ratio (corresponding to a stretching ratio in the MD) and a predetermined blow ratio (corresponding to a stretching ratio in the TD). By controlling the molecular orientation in the MD and the TD, for example, a thermoplastic liquid crystal polymer film having a segment orientation ratio SOR of from 0.8 to 1.4 can be obtained, which is preferable.

As the stretching ratios carried out in such extrusion molding, a stretch ratio (or draw ratio) in the MD, may be, for example, about from 1.0 to 10, preferably about from 1.2 to 7, and more preferably, about from 1.3 to 7. A stretching ratio (or blow ratio) in the TD, may be, for example, about from 1.5 to 20, preferably about from 2 to 15, and still more preferably about from 2.5 to 14.

The ratio of the draw ratio in the TD relative to the draw ratio in the MD (TD/MD) may be, for example, 2.6 or less, preferably about from 0.4 to 2.5.

If necessary, the extrusion molded thermoplastic liquid crystal polymer film may be subjected to further stretching. The stretching method itself is known, and either biaxial stretching or uniaxial stretching may be employed. From the viewpoint of easy control of molecular orientation, biaxial stretching is preferable. The stretching may be carried out using a known machine such as a uniaxial stretching machine, a simultaneous biaxial stretching machine, and a sequential biaxial stretching machine.

Thus-obtained thermoplastic liquid crystal polymer film can be used as an insulating layer of a circuit board directly or in a laminated manner.

If necessary, a known or conventional heat treatment may be performed to adjust the melting point and/or the thermal expansion coefficient of the thermoplastic liquid crystal polymer film (or the insulating layer of the thermoplastic liquid crystal polymer).

High Voltage Circuit Board

The high voltage circuit board (hereinafter, sometimes may be simply referred to as a circuit board) includes an insulating layer and a high voltage circuit board. For example, a circuit board may include a circuit layer as an inner layer circuit existing inside the insulating layer, or may include a circuit layer as an outer layer circuit on the exterior of the insulating layer. Alternatively, the circuit board may include both an inner layer circuit and an outer layer circuit. Further, a conductor layer (for example, a metal layer) may be provided instead of the outer layer circuit. Where the inner layer circuit is provided, it is preferable that the circuit board secures electrical conductivity of the inner layer circuit to an exterior part by means of through holes, conductive pastes, or the like.

Although such a circuit board generates a large amount of heat by the electric circuit due to high voltage application, the circuit board according to the present invention can exhibit satisfactory heat dissipation and suppress occurrence of migration even at high temperatures, because the insulating layer comprises a thermoplastic liquid crystal polymer.

From the viewpoint of improvement in driving force, the high voltage circuit board may have, for example, an AC effective value of dielectric strength exceeding 400 V, preferably 700 V or more, and more preferably 1000 V or more. The upper limit of the AC effective value is not particularly limited to a specific one, and may be about 15 kV.

The circuit board according to the present invention can be suitably used as a pulse control board for adjusting an output by using an energy with a high voltage and a short pulse. Although a switching frequency applied to the circuit board according to the present invention is not particularly limited, considering of short pulse application, the switching frequency may be, for example, about from 1 kHz to 1 MHz, preferably about from 10 kHz to 900 kHz.

For example, Fig. 1 illustrates a schematic cross-sectional view for explaining a high voltage circuit board

according to an embodiment of the present invention. As illustrated in Fig. 1, the circuit board 10 includes inner layer circuits 12 inside an insulating layer 11 comprising a thermoplastic liquid crystal polymer. One side surface in the thickness direction of the insulating layer 11 (hereinafter, simply referred to as one surface) is provided with an outer layer circuit 14, while the other side surface in the thickness direction of the insulating layer 11 (hereinafter, simply referred to as the other surface) is provided with a conductor layer (for example, metal foil) 18. Where the circuit board 10 includes two inner layer circuits 12, 12 each of which are separated from each other in the thickness direction of the insulating layer 11 inside the insulating layer 11, these two inner layer circuits 12, 12 may be electrically connected, for example, via a conductive paste 13 to each other. Further, the inner layer circuit 12 may be electrically connected to the outer layer circuit 14 and/or the conductor layer 18 via a through hole 16. The insulating layer 11 may be provided with an outer layer circuit 14 on both one side and the other side. Alternatively, the insulating layer 11 may be provided with conductor layers 18 both on one surface and on the other surface.

Fig. 2 illustrates a schematic cross-sectional view for explaining a high voltage circuit board according to an embodiment of the present invention. As illustrated in Fig. 2, the circuit board 20 includes: an insulating layer 11 comprising a thermoplastic liquid crystal polymer; an external circuit 14 provided on one surface of the insulating layer 11 as a circuit layer; and a heat dissipation part (for example, a metal plate) 29 provided on the other surface of the insulating layer 11. In Fig. 2, as compared with the configuration of Fig. 1, the insulating layer 11 is in direct contact with the heat dissipation part 29 instead of the conductor layer 18. If necessary, there may be a conductor layer between the insulating layer 11 and the heat dissipation part 29. The joule heat which occurs by application of a high voltage to the external circuit 14 can be dissipated from the heat dissipation part 29 to outside via the insulating layer 11. As in the case of Fig. 1, an inner layer circuit may be provided inside the insulating layer 11 as needed, and in such a case, electric connection may be performed via a through hole and/or a conductive paste.

Fig. 3 illustrates a schematic cross-sectional view for explaining a high voltage circuit board according to an embodiment of the present invention. As illustrated in Fig. 3, a circuit board 30 includes: an insulating layer 31 comprising a thermoplastic liquid crystal polymer, a circuit layer 34 provided on one surface of the insulating layer 31, and a heat dissipation part 29 provided on the other surface of the insulating layer 31.

Hereinafter, explanation will be given on each component constituting the circuit board according to the present invention.

Insulating Layer

The insulating layer comprises a thermoplastic liquid crystal polymer. The insulating layer may contain inorganic-fillers if necessary, but from the viewpoint of suppressing the occurrence of migration, the insulating layer is preferably an inorganic-filler free polymeric insulating layer. More preferably, the insulating layer may be a polymeric insulating layer of the thermoplastic liquid crystal polymer free from inorganic-filler. The polymeric insulating layer free from inorganic-filler can effectively suppress dielectric breakdown caused by occurrence of migration which is sometimes occurred in an insulating layer containing inorganic fillers at a high content.

The insulating layer preferably has a segment orientation ratio of preferably from 0.8 to 1.4, more preferably from 0.9 to 1.3, and still more preferably from 1.0 to 1.2, and particularly preferably from 1.0 to 1.1. Here, the segment orientation ratio SOR is a value measured by the method described in Examples which will be shown later.

The moisture absorption rate (moisture content) of the insulating layer may be preferably 0.06% or less (for example, from 0.03 to 0.06%), and more preferably 0.05% or less. Here, the moisture absorption rate is a value measured by the method described in Examples which will be shown later.

The circuit board according to the present invention is excellent in dielectric property so that, for example, the relative permittivity of the insulating layer at 1 GHz may be preferably 3.5 or less (for example, about from 1.8 to 3.5), and more preferably about from 2.5 to 3.4. By having such a relative permittivity, the circuit board hardly polarizes with respect to an external electric field. Here, the relative permittivity is a value measured by the method described in Examples which will be shown later.

The thermal expansion coefficient of an insulating layer can be suitably set up according to, for example, the material which forms a conductor layer. From the viewpoint of preventing the thermal expansion difference between an insulating layer and a conductor layer, which comes from the heat generated under a high voltage, the thermal expansion coefficient of an insulating layer may be, for example, about 15-23 ppm/°C. The difference in thermal expansion coefficient between the insulating layer and the counterpart of the conductor layer may be, for example, 5 ppm/°C or less, preferably 3 ppm/°C or less, and more preferably 1 ppm/°C or less. Here, the thermal expansion coefficient is a value measured by the method described in Examples which will be shown later.

Furthermore, in the high voltage circuit board according to the present invention, since the insulating layer comprises a thermoplastic liquid crystal polymer, it is possible to suppress the deterioration in insulating property under high humidity conditions. For example, the volume resistivity before moisture absorption measured in accordance with JIS K 6911 (2006) may be, for example, from $2.0 \times 10^{15}$ to $8.0 \times 10^{16}$ $\Omega \cdot cm$ (preferably, from $5.0 \times 10^{15}$ to $5.0 \times 10^{16}$ $\Omega \cdot cm$),

while the volume resistivity after moisture absorption may be from $2.0 \times 10^{15}$ to $8.0 \times 10^{16}$ $\Omega$·cm (preferably, from $5.0 \times 10^{15}$ to $5.0 \times 10^{16}$ $\Omega$·cm). Here, the value after moisture absorption is a value measured using a sample left for 48 hours in an environment of 40°C and 90% RH.

The dielectric breakdown voltage of the insulating layer before moisture absorption measured in accordance with JIS C 2151 (2006) may be, for example, from 150 to 200 kV/mm (from 155 to 190 kV/mm), while the dielectric breakdown after moisture absorption may be from 150 to 200 kV/mm (from 155 to 190 kV/mm). Here, the value after moisture absorption is a value measured using a sample left for 48 hours in an environment of 40°C and 90% RH.

The thickness of the insulating layer can be suitably set up in a circuit board depending on its intended use. For example, from the viewpoint of ensuring good insulation and good heat dissipation, the thickness may be about from 25 to 1000 $\mu$m (for example, about from 25 to 800 $\mu$m), preferably about from 50 to 700 $\mu$m, still more preferably about from 100 to 500 $\mu$m. In particular, in the circuit board according to the present invention, even if the insulating layer has a thinner thickness from the viewpoint of enhancing heat dissipation, the occurrence of dielectric breakdown due to migration can be suppressed because the insulating layer comprises a thermoplastic liquid crystal polymer.

Conductor Layer

The conductor layer is formed of, for example, a metal which at least has conductivity, and if necessary, the conductor layer may be a circuit layer in which a circuit is formed by using a known circuit processing method. Accordingly, the examples of the conductor layer include a conductor circuit, a conductor foil, and a conductor film or sheet. As the conductor forming the conductor layer, there may be mentioned various conductive materials such as gold, silver, copper, iron, nickel, aluminum, or alloy metals thereof. Preferably, conductive materials have an electrical resistivity of $1.0 \times 10^{-6}$ $\Omega$·m or less, more preferably $1.0 \times 10^{-7}$ Q·m or less, and particularly preferably $3.0 \times 10^{-8}$ $\Omega$·m or less.

A known method can be used as a method for forming the conductor layer on the insulating layer of the thermoplastic liquid crystal polymer. For example, the metal layer may be formed by vapor deposition, electroless plating, or electrolytic plating. Furthermore, a metallic foil (for example, copper foil) may be laminated on the surface of an insulating layer by thermo-compression bonding.

As the metallic foil which constitutes a conductor layer, there may be preferably used a metallic foil for electrical connection. In addition to copper foil, there may be exemplified various foils of metal such as gold, silver, nickel, and aluminum, and alloys consisting essentially (for example, 98% by mass or more) of the aforementioned metals.

Copper foil is preferably used among such metallic foil. The copper foil is not particularly limited to a specific one as long as it can be used in a circuit board, and may be either a rolled copper foil or an electrolytic copper foil.

The thickness of the conductor layer can be appropriately set up according to its intended use, and, for example, may be about from 5 $\mu$m to 2 mm, preferably about from 10 $\mu$m to 1 mm, more preferably about from 100 $\mu$m to 500 $\mu$m.

Heat Dissipation Part

From the viewpoint of enhancing the heat dissipation of the circuit board, the circuit board may be further provided with a heat dissipation part for dissipating heat from the insulating layer.

The heat dissipation part is not particularly limited to a specific one as long as it can dissipate heat from the insulating layer, and examples thereof may include materials with high thermal conductivity, for example, metals, such as aluminum and copper, from the viewpoint of excellent heat dissipating property. The materials with high thermal conductivity may have a thermal conductive rate of, for example, 30 W/mK or more, preferably 50 W/mK or more, and more preferably 100 W/mK or more.

Shape of the heat dissipation part can be appropriately determined depending on its intended use, and the heat dissipation part may be preferably a planar part (for example, a plate-shaped part or a sheet-shaped part) since that allows dissipation across the board. While the thickness of the planar part can be appropriately set up depending on the material, it may be, for example, about from 5 $\mu$m to 5 mm, and preferably about from 10 $\mu$m to 2 mm.

Further, the circuit board may have a heat dissipation fin as the heat dissipation part. Such a heat dissipation part enables to dissipate Joule heat generated in the circuit board to outside by having the heat passing through the insulating layer and emitted from the heat dissipation part. The heat dissipation fins may be formed from known or commonly used materials. The heat dissipation fins may be used alone or in combination with a heat-dissipative planar part.

The heat dissipation part and the insulating layer can be appropriately bonded with each other depending on the material used, and may be bonded with, for example, a known or commonly used adhesive or bonded by thermo-compression bonding such as vacuum pressure bonding. From the viewpoint of improving thermal dissipation, heat-conductive adhesive for heat dissipation may be preferably used for bonding.

## High-Voltage Device

The high-voltage device is not be limited to a specific one as long as it is a device (equipment) used under high voltage. The high-voltage device includes the aforementioned circuit board, and an electronic element that is electrically connected to the circuit board. The use of the high-voltage device is decided depending on the type of electronic element to be mounted.

Fig. 4 illustrates a cross-sectional view of a high voltage device 100 including a circuit board 30 according to an embodiment of the present invention. As shown in Fig. 4, the high-voltage device 100 includes a circuit board 30 that has a circuit layer 34, and an electronic element 35 that is electrically connected to the circuit layer 34. The circuit board 30 includes: an insulating layer 31; a circuit layer 34 provided on one surface of the insulating layer 31; and a heat dissipation part 39 provided on the other surface of the insulating layer 31. If necessary, an inner layer circuit may be provided inside the insulating layer 31 of the circuit board 30, and in such a case, electric connection may be performed via a through hole and/or a conductive paste. In such a high-voltage device 100, for example, even where a high-voltage rectangular wave is repeatedly applied at a high frequency to generate high Joule heat in the electronic element 35, heat is dissipated from the heat dissipation part 39 to outside via the insulating layer 31. It should be noted that, although not shown, the high-voltage device 100 may be appropriately provided with other known or commonly used circuit components.

Examples of electronic elements include semiconductor elements such as rectifying diodes, power transistors (power MOSFETs, insulated gate bipolar transistors (IGBT)), thyristors, gate turn-off thyristors (GTOs), and triacs; LED elements; EL elements; solid-state imaging elements; and others. In addition, the high-voltage device may further include circuit components such as connections, resistors, and capacitors. Known or commonly used components/elements can be used for these electronic elements and circuit components. A high-voltage device is particularly useful as a power semiconductor device including a high voltage circuit board and a power semiconductor element.

Since the high-voltage device according to the present invention is provided with a high voltage circuit board including an insulating layer that comprises a thermoplastic liquid crystal polymer, the high-voltage device has excellent insulation reliability, for example, in the applications under high voltage, particularly under high voltage and short pulse. Accordingly, the high-voltage device can realize suppression of not only occurrence of dielectric breakdown due to migration, but also further system destruction. In particular, a high voltage circuit board including an insulating layer that comprises a thermoplastic liquid crystal polymer is excellent in insulation reliability even under high humidity and/or high temperature. Accordingly, the high voltage circuit board enables to suppress not only occurrence of the dielectric breakdown due to migration under high voltage, particularly under high voltage and short pulse, but also further system destruction.

Therefore, examples of the high-voltage devices provided with the high voltage circuit board according to the present invention may include an inverter, a converter, an oscillator, a servo amplifier, an actuator, a power semiconductor device, and others. Such a high-voltage device can be suitably used for, electric transportation means (hybrid vehicles, electric vehicles, trains, etc.), power transmission systems, solar cells, servers, personal computers, industrial robots, various home appliances (air conditioners, refrigerators, etc.), various light-emitting devices (LEDs, ELs), fuel cells, wind power generation, high frequency power sources, motor control, and the like.

## EXAMPLES

Hereinafter, the present invention will be described in detail with reference to Examples, however the present invention is not limited to these Examples. Various physical properties discussed in the Examples and Comparative Examples were measured by the following procedures.

### Melting Point

The melting point was determined by observing thermal behavior of a thermoplastic liquid crystal polymer sample using a differential scanning calorimeter, while the thermoplastic liquid crystal polymer sample was used as a sample of an insulating layer. That is, a melting point of a thermoplastic liquid crystal polymer sample was determined by subjecting the sample to temperature increase at a rate of 20°C/min to completely melt the sample, then to rapid cooling at a rate of 50°C/min to 50°C, and again to temperature increase at a rate of 20°C/min to determine the position of an endothermic peak that occurs during the second temperature increase as the melting point of the polymer sample. If the thermoplastic liquid crystal polymer film to be the test sample is not available, a film-like material obtained by removing the circuit portion etc. from the circuit board may be used as the test sample.

Thickness of Insulating Layer

The thickness of the insulating layer was measured using a "Digimatic Indicator" manufactured by Mitsutoyo Co., Ltd. For the measurement, a sample fragment (length 50 cm × width 50 cm) was collected from the circuit board, and each fragment was randomly measured at 10 points thereof to obtain the thickness value, and the average value of the obtained thickness values was used as the thickness of the insulating layer.

Thermal Expansion Coefficient (ppm/°C)

A thermoplastic liquid crystal polymer film was used as a test sample of the insulating layer. The thermal expansion coefficient of the thermoplastic liquid polymer film is defined as a coefficient obtained by dividing a degree of thermal expansion of a film by a temperature difference, under heat application to the sample at a constant temperature elevation rate from room temperature to near the thermal deformation temperature of the film. That is, the thermal expansion rate can be calculated in the following manner.

First, using a well-known thermomechanical analyzer, one end of the thermoplastic liquid crystal polymer film cut into a thin-strip form is fixed, allowed to apply a tensile load at the opposite end so as to measure an amount of expansion under heating at a constant temperature elevating rate. For example, assuming that: the thermoplastic liquid crystal polymer film strip has a length $L_0$ (mm) at room temperature (25°C) in the tensile load direction, and a length $L_1$ (mm) when heated; and that the room temperature and the heating temperature are expressed by $T_1$ (°C) and $T_2$ (°C), respectively; the thermal expansion coefficient $\alpha L$ can be calculated by the following formula:

$$\alpha L = [(L_1 - L_0)/(T_2 - T_1)]/L_0 \qquad (\text{ppm}/^\circ\text{C})$$

It should be noted that where a thermoplastic liquid crystal polymer film as a test sample for the insulating layer is not available, the film-like material obtained by removing circuit parts, etc. from the circuit board may be used as a test sample.

Segment orientation ratio SOR

A thermoplastic liquid crystal polymer film was used as a test sample of the insulating layer. Using a microwave type molecular orientation meter, a liquid crystal polymer film is inserted into a microwave resonance waveguide tube such that a propagation direction of microwave is perpendicular to the film surface, and electric-field strength (microwave transmission intensity) of microwave transmitting through the film is measured. Then, based on the measured value, m value (referred to as refractive index) is calculated from the following formula:

$$m = (Zo/\Delta z) \times [1 - \nu max/\nu o]$$

Here, Zo represents a device constant, $\Delta z$ represents an average thickness of an object, νmax represents the frequency at which the maximum microwave transmission intensity can be obtained where the frequency of the microwave is varied, and νo represents the frequency at which the maximum microwave transmission intensity can be obtained where the average thickness is zero, that is, where no object is present.

Next, where the rotation angle of the object relative to the direction of oscillation of the microwaves is 0°, that is, where the direction of oscillation of the microwaves is aligned with the direction in which molecules of the object are most oriented as well as in which the minimum microwave transmission intensity is exhibited, an m value obtained in such a case was represented as $m_0$. An m value obtained as $m_{90}$ represents the value of the refractive index where the angle of rotation of the object is 90°. A segment orientation ratio SOR was calculated as $m_0 / m_{90}$.

It should be noted that where a thermoplastic liquid crystal polymer film as a test sample for the insulating layer is not available, the film-like material obtained by removing circuit parts, etc. from the circuit board may be used as a test sample.

Relative Permittivity

The relative permittivity was measured by the resonance perturbation method at a frequency of 1 GHz. A 1 GHz hollow resonator (Kanto Electronics Application Development Co., Ltd.) was connected to a network analyzer ("E8362B" produced by Agilent Technologies Japan, Ltd.) and a minute test sample (width: 2 mm × length: 90 mm) was inserted in the hollow resonator. After insertion, the relative permittivity of the material was measured from the change

in resonance frequency before and after insertion.

It should be noted that where a pre-laminated film is available as a test sample for the insulating layer, the pre-laminated film is used, whereas where a pre-laminated film as a test sample for the insulating layer is not available, the film-like material obtained by removing circuit parts, etc. from the circuit board may be used as a test sample.

Moisture Content

Based on the Karl Fischer method (a method that uses the principle of Karl Fischer titration to absorb water in a solvent and measure the water content by changing the potential difference), by using a trace water content measuring device (Karl Fischer VA-100 manufactured by Mitsubishi Chemical Analytech Co., Ltd.), a test sample in a range of from 7.0 to 1.5 g was cut into a width of 3 mm and a length of 10 mm and put into the sample port, and the values obtained by measuring under the following conditions were used as the moisture absorption rate of the sample.

Heating Temperature: 300°C
$N_2$ purge pressure: 0.2 MPa
Measurement preparation (automatic)

Purge: 1 minute
Preheat: 2 minutes for baking a sample board
Cooling: 4 minutes for cooling the sample board

Measurement

Time for accumulating moisture in a measurement titration cell, i.e., time for sending moisture with $N_2$: 15 minutes

It should be noted that where a pre-laminated film is available as a test sample for the insulating layer, the pre-laminated film is used, whereas where a pre-laminated film as a test sample for the insulating layer is not available, the film-like material obtained by removing circuit parts, etc. from the circuit board may be used as a test sample.

Volume Resistivity

The volume resistivity of the test sample (insulating layer) was measured with reference to JIS K 6911 (2006).

Dielectric Breakdown Voltage

The dielectric breakdown voltage of the test sample (insulating layer) was measured with reference to JIS C 2151 (2006).

Presence/Absence of Dielectric Breakdown under High Temperature

It is possible to determine occurrence of dielectric breakdown determined by the presence/absence of a rapid increase in the current value during a current application at 100 kV/mm and 100 kHz at a temperature condition of 80°C.

Example 1

A copolymer of p-hydroxybenzoic acid and 6-hyeroxy-2-naphthoic acid (molar ratio: 73/27) was melt-extruded, and a film having a melting point of 310°C, a thermal expansion coefficient of 18 ppm/°C, a film thickness of 100 μm, and an SOR of 1.02 was obtained by an inflation molding method.

Next, an electrolytic copper foil (thermal expansion coefficient of 18 ppm/°C) having a thickness of 18 μm was overlaid on one surface of the film, while an aluminum sheet having a thickness of 100 μm was overlaid on the other surface to obtain a stacked material, and the stacked material was thermo-compression bonded at 300°C under a pressure of 4 MPa so as to produce a laminate of electrolytic copper foil / thermoplastic liquid crystal polymer film / aluminum sheet. The electrolytic copper foil in the obtained laminate was subjected to photosensitive resist treatment, light exposure, and etching processing to print circuit wiring, so as to produce a circuit board comprising a thermoplastic liquid crystal polymer film as an insulating layer, a circuit layer on one surface of the insulating layer, and a heat-dissipating planar part (aluminum sheet) on the other surface of the insulating layer. The table 7 shows physical characteristics of the obtained circuit board.

Further, a heat dissipating part (aluminum heat sink) was adhered to the aluminum sheet with a heat conductive silicone grease for heat dissipation to obtain a circuit board having the heat dissipating part. In this circuit board, in

addition to the aluminum sheet, an aluminum heat sink is further provided as a heat dissipating member, so that the heat dissipating property can be improved.

Comparative Example 1

On an aluminum metal base substrate having a thickness of 2.0 mm, was coated an epoxy resin (insulating resin) containing $Al_2O_3$ (alumina) particles having an average particle size of 5.0 μm dispersed in a proportion of 70 vol% as inorganic fillers to form a coated composite insulating layer. The coated composite insulating layer had a thickness of about 200 μm as a thickness after curing. The relative permittivity of this composite insulating layer was 5.0.

On the coated composite insulating layer, was overlaid an electrolytic copper foil (conductor circuit) having a thickness of 105 μm and then heat-treated at 150°C for 5 hours to cure the coated composite insulating layer. Then, the copper foil was subjected to etching to remove unnecessary parts other than circuit to form a test circuit, thereby the circuit board of Comparative Example 1 was obtained. Table 7 shows characteristics of the obtained circuit board.

Comparative Example 2

An electrolytic copper foil (thermal expansion coefficient: 18 ppm/°C) having a thickness of 8 μm was applied to one surface of a polyimide film (thickness 100 μm, no melting point, "Kapton" manufactured by Toray DuPont Co., Ltd.,), and an aluminum sheet having a thickness of 100 μm was applied to the other surface of the polyimide film, both via an adhesive to obtain a laminate. The electrolytic copper foil of the obtained laminate was subjected to photosensitive resist treatment, light exposure, and etching processing to print circuit wiring so as to produce a circuit board comprising the polyimide film as an insulating layer, a circuit layer provided on one surface of the insulating layer, and a heat dissipating planar part (aluminum sheet) provided on the other surface of the insulating layer. Table 7 shows characteristics of the obtained circuit board.

Table 7

| | Relative Permittivity | Moisture Content (%) | Volume Resistivity (Ω·cm) | | Insulation Destruction Voltage (kV/mm) | | Insulation Destruction under High Temperature |
|---|---|---|---|---|---|---|---|
| | | | Before Moisture Absorption | After Moisture Absorption | Before Moisture Absorption | After Moisture Absorption | |
| Example 1 | 3.2 | 0.04 | $10^{16}$ | $10^{16}$ | 180 | 180 | not occurred |
| Comparative Example 1 | 5.0 | 0.10 | $10^{13}$ | $10^{12}$ | 80 | 80 | Occurred |
| Comparative Example 2 | 3.2 | 1.00 | $10^{17}$ | $10^{15}$ | 180 | 140 | Occurred |

As shown in Table 7, Example 1 shows lower relative permittivity than that of Comparative Example, and further exhibits extremely low moisture content. Furthermore, in Example 1, the volume resistivities before and after moisture absorption show the same value with each other, whereas in Comparative Examples 1 and 2, the volume resistivities before and after moisture absorption change greatly and are different from each other by one or two digits. Accordingly, Example 1 achieves extremely smaller change rate in volume resistivity compering with Comparative Examples 1 and 2. Furthermore, the volume resistivity of Example 1 after moisture absorption shows a value larger than each moisture absorption of Comparative Examples 1 and 2.

With respect to the dielectric breakdown voltage, Example 1 does not cause dielectric breakdown until it reaches a value more than twice as high as that of Comparative Example 1. In Example 1, even after moisture absorption, the dielectric breakdown voltage shows a high value, without changing. Further, in Example 1, dielectric breakdown does not occur during an application of a short pulse high voltage at a high temperature.

On the other hand, Comparative Example 1 has an extremely high relative permittivity as compared with Example 1, and Comparative Example 2 has an extremely high moisture content as compared with Example 1. Further, in both Comparative Examples 1 and 2, the volume resistivities drastically change after moisture absorption, and both show lower volume resistivities than that of Example 1. Further, regarding the dielectric breakdown voltage, Comparative Example 1 shows a value significantly smaller than that of Example 1, and Comparative Example 2 shows a value of dielectric breakdown voltage after moisture absorption smaller than that of Example 1. Further, in Comparative Examples 1 and 2, dielectric breakdowns occur during an application of a short pulse high voltage at high temperature.

INDUSTRIAL APPLICABILITY

Since the high voltage circuit board according to the present invention has high insulation reliability under high voltage, it is suitable for various applications used under high voltage. For example, the high voltage circuit board according to the present invention is advantageously used for high voltage devices such as inverters, converters, oscillators, servo amplifiers, and actuators, particularly power semiconductor devices including high voltage circuit boards and power semiconductor elements.

As described above, the present invention has been described as to the preferred embodiments thereof with reference to the figures, but one skilled in the art would easily make various changes or modifications in view of the present description, without departing from the spirit or scope of the present invention. Accordingly, such changes and modifications are construed as within the scope of the invention as defined from the scope of the claims.

## Claims

1. A high voltage circuit board comprising:

    an insulating layer comprising a thermoplastic liquid crystal polymer, and
    a high voltage circuit layer.

2. The high voltage circuit board according to claim 1, wherein the insulating layer has a relative permittivity of 3.5 or less at 1 GHz.

3. The high voltage circuit board according to claim 1 or 2, further comprising a heat dissipation part for dissipating heat from the insulating layer.

4. The high voltage circuit board according to any one of claims 1 to 3, wherein the insulating layer is an inorganic-filler free polymeric insulating layer.

5. The high voltage circuit board according to any one of claims 1 to 4, wherein the insulating layer has a thickness of from 25 to 1000 μm.

6. The high voltage circuit board according to any one of claims 1 to 5, wherein the insulating layer has a segment orientation ratio SOR of from 0.8 to 1.4.

7. The high voltage circuit board according to any one of claims 1 to 6, which is used as a pulse control board.

8. The high voltage circuit board according to any one of claims 1 to 7, which is used as a power semiconductor device.

**9.** A high voltage device comprising:

the high voltage circuit board recited in any one of claims 1 to 8, and
an electronic element.

**10.** A power semiconductor device comprising:

the high voltage circuit board recited in any one of claims 1 to 8, and
a power semiconductor element.

Fig. 1

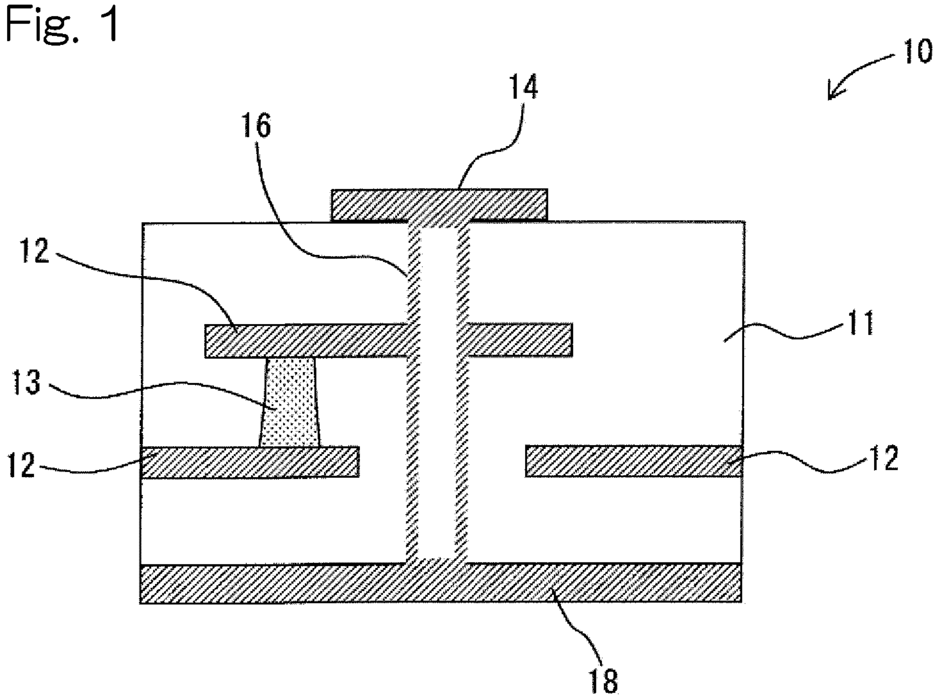


Fig. 2

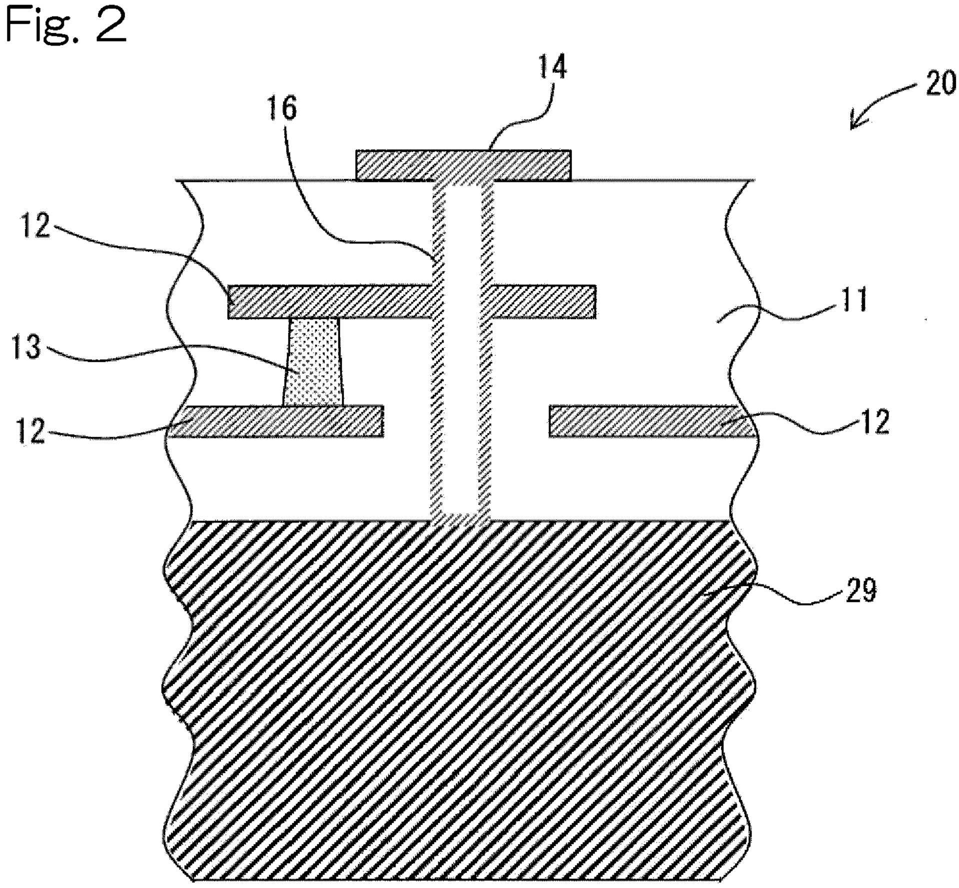

Fig. 3

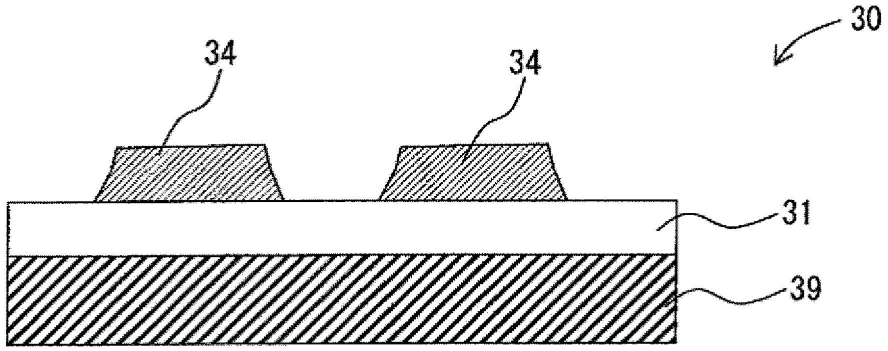


Fig. 4

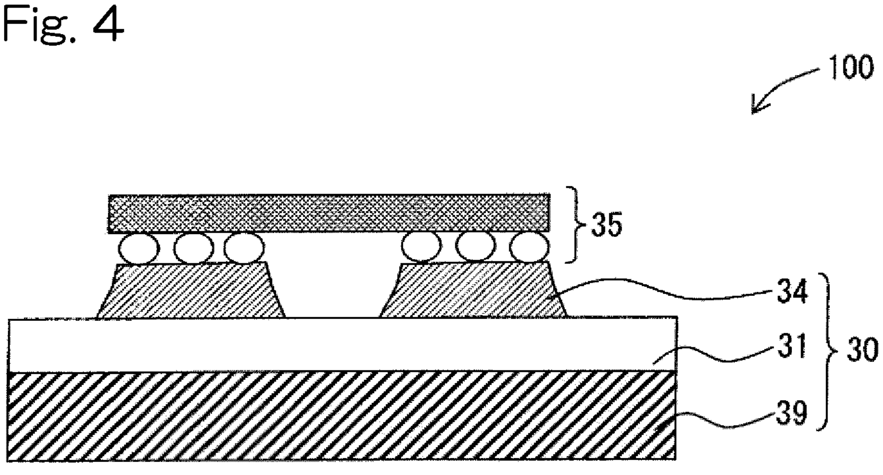

**INTERNATIONAL SEARCH REPORT**

International application No. PCT/JP2019/046537

A. CLASSIFICATION OF SUBJECT MATTER

Int. Cl. H01L23/12(2006.01)i, H01L23/14(2006.01)i, H01L23/36(2006.01)i, H05K1/02(2006.01)i, H05K1/03(2006.01)i, H05K3/46(2006.01)n
FI: H01L23/14 R, H05K1/02 F, H05K1/03 610M, H01L23/12 J, H01L23/36 C, H05K3/46 U, H05K3/46 T

According to International Patent Classification (IPC) or to both national classification and IPC

B. FIELDS SEARCHED

Minimum documentation searched (classification system followed by classification symbols)
Int. Cl. H01L23/12, H01L23/14, H01L23/36, H05K1/02, H05K1/03, H05K3/46

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2002-176121 A (SANYO ELECTRIC CO., LTD.) 21 June 2002, paragraphs [0031]-[0045], all drawings, paragraphs [0001], [0002], [0031]-[0045], fig. 1, 2 | 1-2, 5, 8-10<br>6 |
| X | WO 2017/217369 A1 (MITSUBISHI ELECTRIC CORP.) 21 December 2017, paragraphs [0010]-[0053], fig. 1-4 | 1, 3, 8-10 |
| X | JP 2004-200668 A (SANYO ELECTRIC CO., LTD.) 15 July 2004, paragraphs [0028]-[0059], fig. 1-7 | 1-2, 4, 8-10 |
| X | JP 2003-218272 A (SONY CORP.) 31 July 2003, paragraphs [0035]-[0070], fig. 1-11 | 1-2, 7-10 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24.01.2020 | 04.02.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/046537

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2017/154811 A1 (KURARAY CO., LTD.) 14 September 2017, paragraphs [0052]-[0062] | 6 |
| A | WO 2017/077837 A1 (MURATA MFG. CO., LTD.) 11 May 2017, paragraphs [0021]-[0056], fig. 1-5 | 1-10 |

Form PCT/ISA/210 (continuation of second sheet) (January 2015)

**INTERNATIONAL SEARCH REPORT**
Information on patent family members

International application No.
PCT/JP2019/046537

| Patent Documents referred to in the Report | Publication Date | Patent Family | Publication Date |
|---|---|---|---|
| JP 2002-176121 A | 21.06.2002 | (Family: none) | |
| WO 2017/217369 A1 | 21.12.2017 | DE 112017002961 T5<br>paragraphs [0009]-[0052], fig. 1-4<br>CN 109314063 A | |
| JP 2004-200668 A | 15.07.2004 | US 2004/0140551 A1<br>paragraphs [0045]-[0091], fig. 1-7<br>CN 1516272 A | |
| JP 2003-218272 A | 31.07.2003 | US 2005/0146403 A1<br>paragraphs [0057]-[0097], fig. 7-17<br>WO 03/063238 A1<br>CN 1623229 A<br>KR 10-2004-0086286 A | |
| WO 2017/154811 A1 | 14.09.2017 | CN 108712962 A<br>paragraphs [0095]-[0105]<br>KR 10-2018-0120694 A | |
| WO 2017/077837 A1 | 11.05.2017 | US 2018/0242459 A1<br>paragraphs [0026]-[0063], fig. 1-5<br>CN 208159004 U | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018227171 A
- JP 2010186789 A